# NEUE EUROPÄISCHE PATENTSCHRIFT

(11) **EP 1 051 761 B2**
(45) Veröffentlichungstag und Bekanntmachung des Hinweises auf die Entscheidung über den Einspruch: **08.07.2015**
(45) Hinweis auf die Patenterteilung: 09.11.2005
(21) Anmeldenummer: 99973355.3
(22) Anmeldetag: 11.09.1999
(51) Int. Cl.: H01L 41/083, H01L 41/053

(54) **PIEZOELEKTRISCHER AKTOR**
PIEZOELECTRIC ACTUATOR
ACTIONNEUR PIEZOÉLÈCTRIQUE

(30) Priorität: 05.12.1998 DE 19856201
(43) Veröffentlichungstag der Anmeldung: 15.11.2000
(73) Patentinhaber: ROBERT BOSCH GMBH, 70442 Stuttgart (DE)
(72) Erfinder: HEINZ, Rudolf, D-71272 Renningen (DE); SCHMOLL, Klaus-Peter, D-74251 Lehrensteinsfeld (DE)
(86) Internationale Anmeldenummer: PCT/DE1999/002882
(87) Internationale Veröffentlichungsnummer: WO 2000/035027

(56) Entgegenhaltungen:
- US-A- 5 168 189

## Beschreibung

### Stand der Technik

Die Erfindung geht aus von einem piezoelektrischen Aktor, insbesondere zur Betätigung von Steuerventilen oder Einspritzventilen an Verbrennungsmotoren in Kraftfahrzeugen, mit einem piezoelektrischen Aktorkörper in Form eines vielschichtigen Laminats aus aufeinandergeschichteten Lagen piezoelektrischen Materials und dazwischenliegenden metallischen bzw. elektrisch leitenden, als Elektroden dienenden Schichten, wobei eine der Stirnseiten des Aktorkörpers an einem ruhenden metallischen Aktorfuß festgelegt ist und die andere Stirnseite an eine mit dem Aktorhub bewegliche metallische Halteplatte angrenzt.

Ein derartiger piezoelektrischer Aktor ist zum Beispiel bekannt aus der DE 196 50 900 A1 der Robert Bosch GmbH und der US 5,168, 189.

Aus der DE 196 15 694 C1 ist darüber hinaus ein Piezoaktor bekannt, dessen Kopf- und Fußbereich elektrisch inaktive Keramikschichten mit dazwischen liegender Elektrodenstruktur aufweisen.

Wie allgemein bekannt, können piezoelektrische Aktoren zum Beispiel für Einspritzventile eines Kraftfahrzeugmotors sowie in Bremssystemen mit Antiblockiersystem und Antischlupfregelungen eingesetzt werden

Derartige mit piezoelektrischen Aktoren ausgestattete Einspritzventile besitzen eine durch ein stößelartiges Verschlußorgan gesteuerte Einspritzdüse. Am Stößel ist eine düsenseitige Wirkfläche angeordnet, die vom Druck des der Düse zugeführten Kraftstoffs beaufschlagt wird, wobei die Druckkräfte den Stößel in Öffnungsrichtung des Verschlußorganes zu drängen suchen. Der Stößel ragt mit einem plungerartigen Ende, dessen Querschnitt größer ist als die vorgenannte Wirkfläche, in eine Steuerkammer hinein. Der dort wirksame Druck sucht den Stößel in Schließrichtung des Verschlußorganes zu bewegen. Die Steuerkammer ist über eine Eingangsdrossel mit der unter hohem Druck stehenden Kraftstoffzufuhr und über ein in der Regel gedrosseltes bzw. mit einer Ausgangsdrossel kombiniertes Auslassventil mit einer nur geringen druckaufweisenden Kraftstoffrückführleitung verbunden. Bei geschlossenem Auslassventil steht in der Steuerkammer ein hoher Druck an, durch den der Stößel gegen den Druck an seiner düsenseitigen Wirkfläche in Schließrichtung des Verschlußorganes bewegt bzw. in Verschlußstellung gehalten wird. Beim Öffnen des Auslaßventiles fällt der Druck in der Steuerkammer ab, wobei das Maß des Druckabfalles durch die Bemessung der Eingangsdrossel und des Drosselwiderstandes des geöffneten Ausgangsventiles bzw. der damit kombinierten Ausgangsdrossel bestimmt wird. Im Ergebnis vermindert sich der Druck in der Steuerkammer bei geöffnetem Auslaßventil derart, daß der Stößel aufgrund der an seiner düsenseitigen Wirkfläche wirksamen Druckkräfte in Öffnungsrichtung des Verschlußorgans bewegt bzw. in Offenstellung gehalten wird.

Im Vergleich mit elektromagnetisch betätigten Einspritzventilen können piezoelektrische Aktoren schneller schalten. Allerdings muß beim Aufbau eines piezoelektrischen Aktors beachtet werden, daß durch innere Verluste im piezoelektrischen Körper des Aktors Verlustwärme entsteht, die abgeführt werden muß, damit sich der Aktor nicht überhitzt. Da die Keramikmaterialien der Piezokeramik eine schlechte Wärmeleitfähigkeit haben, ist besonders bei langen Aktoren, deren Länge größer ist als ihre Breite, die Ableitung innerhalb des im wesentlichen aus Keramikmaterial bestehenden Aktorkörpers ungünstig.

Durch die im aktiven Teil des Aktorkörpers liegenden Elektroden ist dessen Wärmeleitfähigkeit quer zu den Elektrodenschichten um den Faktor 3 bis 5 höher als senkrecht dazu, da das piezoelektrische Keramikmaterial ein schlechter Wärmeleiter ist. Dieser Faktor hängt natürlich von den geometrischen Verhältnissen, wie der Dicke der Keramikschichten, der Dicke der Elektrodenschichten und vom Abstand der nicht durchgehenden Elektrode vom Rand des Aktorkörpers ab. Da die Konvektion, d. h. die Abgabe der Wärme an die Luft schlecht ist, muß der größte Teil der Wärme über die Stirnflächen abgeführt werden. Da die Wärmeleitung, wie erwähnt, senkrecht zu den Elektrodenschichten schlecht ist, nimmt die Wärme, vereinfacht dargestellt, den folgenden Weg. Sie wird durch die innenliegenden Elektroden des aktiven Teils des Aktorkörpers zu den Außenelektroden geführt. Dort wird sie relativ gut verteilt und gelangt so schnell in die Nähe der Stirnseiten des Aktorkörpers. Da die Außenelektroden keinen Kontakt zum metallischen Aktorfuß sowie zur metallischen Halteplatte im Bereich des Aktorkopfs haben, muß die Wärme über die schlecht leitenden Stirnseiten des Aktorkörpers fließen. Da die Außenelektroden außen liegen, fließt auch die Wärme nur in den Außenbereichen des Aktorkörpers zur Stirnfläche.

Eine theoretisch mögliche Kühlung des Aktors mit einem flüssigen Kühlmittel, wie zum Beispiel Kraftstoff, Wasser, Motoröl und dergleichen ist ungünstig, zum einen wegen der Gefahr eines Kurzschlusses durch den auch im Kraftstoff und im Motoröl enthaltenen Wasseranteil und zum anderen wegen der Verteuerung des Aktormoduls aufgrund aufwendiger Abdichtungen, die ein Austreten des verwendeten Kühlmittels, insbesondere bei Erwärmung des Aktors aus dem Aktormodul ausschließen müssen.

### Aufgaben und Vorteile der Erfindung

Es ist deshalb Aufgabe der Erfindung einen gattungsgemäßen piezoelektrischen Aktor so zu ermöglichen, daß eine sichere Kühlung des durch den Betrieb sich erwärmenden Aktorkörpers ohne Verwendung eines flüssigen Kühlmittels möglich ist, daß der piezoelektrische Aktor einfach montiert werden kann und keine besonderen Abdichtungen, wie bei einer Flüssigkeitskühlung benötigt.

Zur Lösung dieser Aufgabe ist ein erfindungsgemäßer piezoelektrischer Aktor gemäß Anspruch 1 vorgesehen.

Die Bezeichnung "blinde Elektrode" bedeutet in diesem Fall, daß diese zur Wärmeableitung des Aktorkörpers an dessen Stirnseiten eingebrachten Elektroden nach keiner Seite bis zum Rand gehen. Sie haben somit keinen metallischen Kontakt mit den Außenelektroden, d. h. die elektrischen Eigenschaften bleiben unverändert.

Für die Wärmeableitung hat das jedoch folgenden Effekt. Nach Überwindung des kurzen Randabstands zwischen Außenelektrode und der blinden Elektrode oder den blinden Elektroden kann die Wärme leicht von außen nach innen eindringen, um dann den letzten Rest des Ableitungsweges die ganze Aktorstirnfläche nutzend bis zum metallischen Aktorfuß und zur beweglichen metallischen Halteplatte zurückzulegen. Damit läßt sich die Wärmeableitung durch den Engpaß an den Stirnseiten des Aktorkörpers verbessern und die maximale thermische Belastung des Aktors reduzieren.

In bevorzugter Ausführungsform ist der piezoelektrische Aktor so gestaltet, daß in jeder der passiven Deckschichten des Aktorkörpes mehrere parallele blinde Elektroden im Abstand voneinander liegen.
Bei einem solchen Vielschichtaktor beträgt die Schichtdicke des piezoelektrischen Materials zum Beispiel 0,1mm. Dann können in einer etwa 1,5mm Höhe betragenden oberen und unteren Deckschicht zum Beispiel 14 blinde Elektroden im Abstand von 0,1mm liegen.

Hier ist vorausgesetzt, daß der Schichtaufbau in den Deckschichten mit dem des aktiven Bereichs des Aktorkörpers, was die Schichtdicke angeht, konform ist.

Ein solcher Schichtaufbau des Aktorkörpers mit identischer Schichtdicke ist vom Gesichtspunkt einer kostengünstigen Fertigung des Aktorkörpers zu bevorzugen. Sie ist jedoch nicht für die Erfindung unbedingt notwendig. Die Schichtdicke im aktiven Bereich kann sich von der in den Deckschichten unterscheiden. Weiterhin können in der unteren Deckschicht eine größere oder kleinere Anzahl blinder Elektroden vorgesehen sein als in der oberen Deckschicht.

Nachstehend werden die obigen und weitere vorteilhafte Merkmale des erfindungsgemäßen piezoelektrischen Aktors anhand der Zeichnung näher beschrieben.

Zeichnung
- Figur 1: zeigt im Längsschnitt einen Teil eines piezoelektrischen Aktormoduls, dessen Aktorkörper blinde Elektroden in seiner oberen und unteren Deckschicht aufweist.
- Figur 2: zeigt in vergrößerter Darstellung eine bevorzugte Ausführungsform des erfindungsgemäßen piezoelektrischen Aktors mit mehreren parallel liegenden blinden Elektroden in der oberen und unteren Deckschicht.
- Figur 3: eine variante der in Figur 2 dargestellten Ausführungsform.

### Ausführungsbeispiele

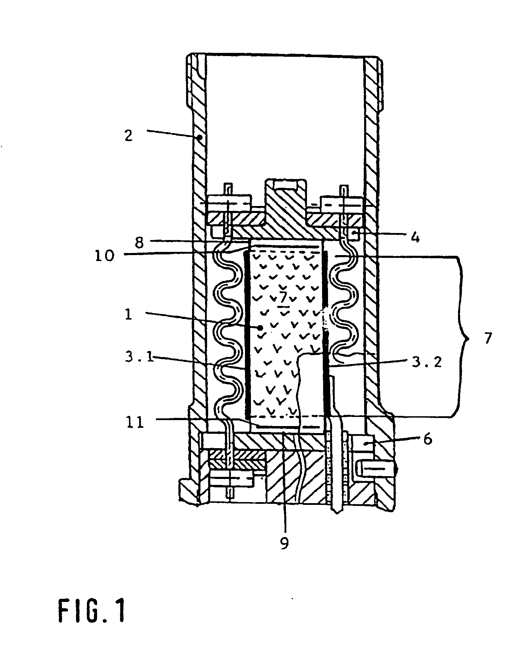

Bei dem in Figur 1 im Längsschnitt dargestellten Abschnitt eines erfindungsgemäßen piezoelektrischen Aktors ist ein Aktorkörper 1, der die Form eines vielschichtigen Laminats aus aufeinandergeschichteten Lagen piezoelektrischen Materials und dazwischenliegenden metallischen bzw. elektrisch leitenden, als Elektroden dienenden Schichten hat, mit seinen Stirnseiten durch (nicht bezeichnete) Federbänder zwischen einem unteren ruhenden metallischen Aktorfuß 6 und einer oberen, am Aktorkopf liegenden, axial beweglichen metallischen Halteplatte 4 elastisch vorgespannt. Der Aktorkörper 1 ist von einer metallischen Aktorwand 2 eingeschlossen. Die Bezeichnungen "unten" und "oben" beziehen sich auf die Lage des Aktors in der Zeichnung.

Wenn der Aktorkörper 1 mit einer pulsierenden elektrischen Spannung an seinen Elektroden beaufschlagt wird, führt er analog pulsierende Hübe unter Änderung des Abstandes zwischen seinen zwischen der oberen beweglichen Halteplatte 4 und dem fixierten unteren Aktorfuß 6 durch die Federbänder eingespannten Stirnseiten aus. Diese Hübe werden von der beweglichen Halteplatte 4 über einen (nicht gezeigten) Kolben auf die (ebenfalls nicht gezeigte) Nadel eines Ventils übertragen. Zu bemerken ist auch, daß die die elektrische Spannung zu den aktiven Elektroden des Aktorkörpers leitenden gemeinsamen Außenelektroden 3.1 und 3.2 seitlich die volle Länge des aktiven Bereiches 7 überdecken.

Der aktive Bereich 7 ist nach oben und unten jeweils von einer passiven Deckschicht 8 und 9 begrenzt. Diese passiven Deckschichten 8 und 9 dienen zunächst dem Schutz und elektrischen Isolation und der Abgrenzung des aktiven Bereichs 7 des Aktorkörpers 1 gegenüber der metallischen Halteplatte 4 und dem ebenfalls metallischen Aktorfuß 6.

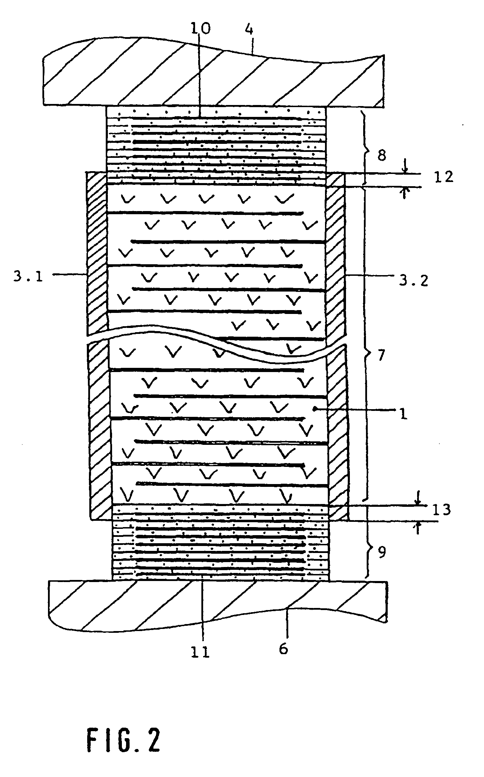

Obwohl dies in Figur 1 nicht deutlich gemacht ist, ragen die gemeinsamen Außenelektroden 3.1 und 3.2 etwas in den Bereich der Deckschichten 8 und 9 hinein, wie dies in Figur 2 durch Überlappungszonen 12 und 13 angedeutet ist. Allerdings dürfen sie weder die obere metallische Halteplatte 4 noch den Aktorfuß 6 berühren, da sonst ein elektrischer Kurzschluß entstehen würde.

Erfindungsgemäß sind in die Deckschichten 8 und 9 blinde Elektroden 10, 11 eingebracht. "Blind" heißt in diesem Fall, daß die Elektroden nach keiner Seite bis zum Rand gehen. Sie haben somit keinen metallischen Kontakt mit den gemeinsamen Außenelektroden 3.1 und 3.2, d. h., die elektrischen Eigenschaften bleiben unverändert.

Für die Wärmeleitung hat das jedoch folgenden Effekt. Nach Überwindung des kurzen Randabstandes zwischen Außenelektroden 3.1 und 3.2 und den blinden Elektroden 10, 11 kann die Wärme leicht von außen, d. h. von den Außenelektroden 3.1, 3.2 und den äußeren Schichten des Aktorkörpers nach innen eindringen, um dann den letzten Rest des Weges auf voller Breite des Aktors jeweils bis zur beweglichen oberen Halteplatte 4 und nach unten zum metallischen ruhenden Aktorfuß 6 zurückzulegen.

In Figur 1 ist jeweils nur eine blinde Elektrode 10, 11 in jeder Deckschicht 8, 9 dargestellt.

Figur 2 zeigt dagegen eine bevorzugte Ausführungsform eines piezoelektrischen Aktors, bei der sowohl in der oberen Deckschicht 8 als auch in der unteren Deckschicht 9 die an den aktiven Bereich 7 nach oben und unten anschließen, mehrere blinde Elektroden 10, 11 parallel im Abstand zueinander liegen. Der Abstand der blinden Elektroden 10, 11 ist bei der bevorzugten Ausführungsform durch die Dicke der die Deckschichten 8, 9 bildenden passiven Pezokeramikschichten definiert.

Die Schichtdicke der passiven Piezokeramikschichten beträgt in einer realen Ausführung zum Beispiel 0,1mm. In diesem Fall können in der oberen und unteren Deckschicht 8, 9, wenn diese zum Beispiel 1,5mm dick sind, 14 blinde Elektroden 10, 11 eingebracht sein.

Um deutlich zu machen, daß die Schichtdicke der piezoelektrischen Schichten im aktiven Bereich 7 des Aktorkörpers 1 nicht notwendigerweise mit der Schichtdicke in den Deckschichten 8, 9 übereinstimmen muß, sind diese in Figur 2 unterschiedlich dargestellt. Im realen Fall jedoch wird zur kostengünstigen Herstellung eines Vielschichtaktors die Schichtdicke im aktiven Bereich identisch mit der in den Deckschichten 8, 9 sein.

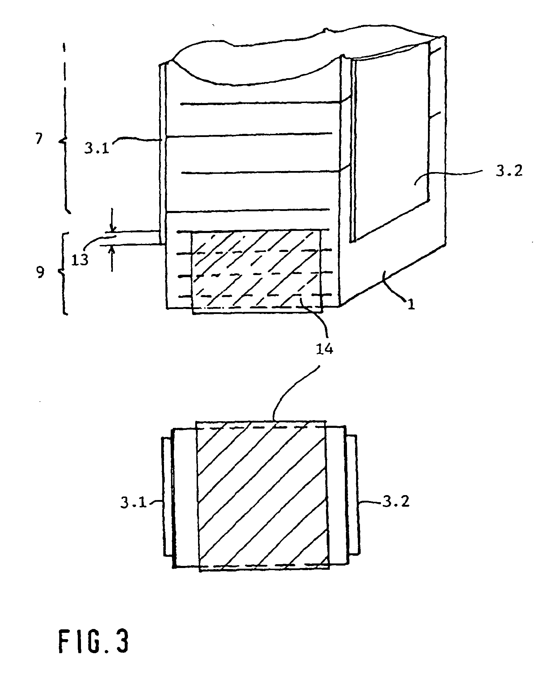

Figur 3 zeigt eine vorteilhafte Variante der in Figur 2 gezeigten Ausführungsform, wobei im Bereich der passiven Zonen oder Deckschichten 8, 9 außen eine elektrisch leitende Schicht 14 liegt, die die blinden Elektroden 10, 11 kurzschließt und dadurch die Wärmeableitung steigert.

Piezoelektrische Aktoren, die gemäß der Erfindung gestaltet sind, können in Common-Rail-Diesel-Injektorsystemen und in PDE-Injektorsystemen eingesetzt werden. Auch sind Benzindirekteinspritzventile mit solchen piezoelektrischen Aktoren vorteilhaft zu realisieren.

## Patentansprüche

1. Piezoelektrischer Aktor, insbesondere zur Betätigung von Steuerventilen oder Einspritzventilen an Verbrennungsmotoren in Kraftfahrzeugen, mit einem piezoelektrischen Aktorkörper (1) in Form eines vielschichtigen Laminats aus aufeinandergeschichteten Lagen piezoelektrischen Materials und dazwischenliegenden metallischen bzw. elektrisch leitenden, als Elektroden dienenden Schichten, wobei die als Elektroden dienenden Schichten durch gemeinsame Außenelektroden (3.1, 3.2) elektrisch miteinander verbunden sind, und wobei eine der Stirnseiten des Aktorkörpers (1) an einem ruhenden metallischen Aktorfuß (6) festgelegt ist und die andere Stirnseite an eine mit dem Aktorhub bewegliche metallische Halteplatte (4) angrenzt, wobei
das piezoelektrische Material an beiden Stirnseiten blinde metallische Elektroden (10, 11) aufweist, die jeweils in einer passiven piezokeramischen Deckschicht (8, 9) zwischen der jeweiligen äußersten aktiven Piezokeramikschicht und der beweglichen Halteplatte (4) sowie dem Aktorfuß (6) liegen, wobei
die gemeinsame Elektroden (3.1 und 3.2) über die volle Länge des aktiven Bereichs (7) des Aktorkörpers hinausragen, so dass oben und unten ein Überlappungsbereich (12, 13) mit den passiven Deckschichten (8, 9) entsteht.

2. Piezoelektrischer Aktor nach Anspruch 1, **dadurch gekennzeichnet, dass** in jeder passiven Deckschicht (8, 9) mehrere parallele blinde Elektroden (101-110, 111-119) im Abstand voneinander vorgesehen sind.

3. Piezoelektrischer Aktor nach Anspruch 2, **dadurch gekennzeichnet, dass** die Abstände der blinden Elektroden jeweils gleich sind.

4. Piezoelektrischer Aktor nach einem der Ansprüche 2 bis 3, **dadurch gekennzeichnet, dass** der gegenseitige Abstand der blinden Elektroden gleich oder kleiner als der Elektrodenabstand im aktiven Bereich ist.

5. Piezoelektrischer Aktor nach einem der vorangehenden Ansprüche, **dadurch gekennzeichnet, dass** die blinden metallischen Elektroden (10, 11) durch eine elektrisch leitende Schicht (14) kurzgeschlossen sind, so dass die Wärmeleitung zwischen den blinden Elektroden intensiviert wird, ohne dass die elektrische leitende Schicht (14) mit den Außenelektroden (3.1, 3.2) in Kontakt kommt.

## Claims

1. Piezoelectric actuator, in particular for actuating control valves or injection valves at internal combustion engines in motor vehicles, having a piezoelectric actuator body (1) in the form of a multilayer laminate composed of sheets of piezoelectric material layered on top of one another with metallic or electrically conductive layers serving as electrodes between them, the layers serving as electrodes being electrically connected to one another by common outer electrodes (3.1, 3.2), and one of the end sides of the actuator body (1) being fixed to a stationary metallic actuator foot (6), while the other end side adjoins a metallic holding plate (4) which can move with the actuator displacement, wherein the piezoelectric material has blind metallic electrodes (10, 11) at both end sides, which metallic electrodes are each located in a passive piezoceramic covering layer (8, 9) between the respective outermost active piezoceramic layer and the moveable holding plate (4) and the actuator foot (6), wherein the common electrodes (3.1 and 3.2) project beyond the full length of the active region (7) of the actuator body, so that an overlap region (12, 13) with the passive covering layers (8, 9) is formed at the top and bottom.

2. Piezoelectric actuator according to Claim 1, **characterized in that** a plurality of parallel blind electrodes (101-110, 111-119) are provided spaced apart from one another in each passive covering layer (8, 9).

3. Piezoelectric actuator according to Claim 2, **characterized in that** the spacings between the blind electrodes are in each case identical.

4. Piezoelectric actuator according to either of Claims 2 and 3, **characterized in that** the spacing between the blind electrodes is less than or equal to the electrode spacing in the active region.

5. Piezoelectric actuator according to one of the preceding claims, **characterized in that** the blind metallic electrodes (10, 11) are short-circuited by an electrically conductive layer (14), so that the heat conduction between the blind electrodes is made more intensive without the electrically conductive layer (14) coming into contact with the outer electrodes (3.1, 3.2).

## Revendications

1. Actionneur piézo-électrique notamment pour commander des soupapes de commande ou des injecteurs de moteurs à combustion interne dans des véhicules automobiles, comportant un corps d'actionneur piézo-électrique (1) sous la forme d'une stratification à plusieurs couches de matière piézo-électrique superposées avec interposition de couches métalliques ou électroconductrices servant d'électrodes, les couches servant d'électrodes étant reliées électriquement les unes aux autres par des électrodes extérieures communes (3.1, 3.2), et l'une des faces frontales du corps d'actionneur (1) étant fixée à un pied (6) métallique fixe de l'actionneur et l'autre face frontale étant adjacente à une plaque de fixation métallique (4), mobile en fonction du mouvement de l'actionneur,
la matière piézo-électrique au niveau des deux faces frontales comportant des fausses électrodes métalliques (10, 11) situées chaque fois dans une couche de recouvrement piézo-céramique passive (8, 9) entre la couche de céramique piézo-électrique active respective la plus extérieure et la plaque de fixation mobile (4) ainsi que le pied (6) de l'actionneur,
les électrodes communes (3.1 et 3.2) dépassant de toute la longueur de la zone active (7) du corps d'actionneur de façon à former en haut et en bas une zone de chevauchement (12, 13) avec les couches de recouvrement passives (8, 9).

2. Actionneur piézo-électrique selon la revendication 1, **caractérisé en ce que** plusieurs fausses électrodes (101-110, 111-119) parallèles sont prévues de façon écartée les unes des autres dans chaque couche de recouvrement passive (8, 9).

3. Actionneur piézo-électrique selon la revendication 2, **caractérisé en ce que** les distances entre les fausses électrodes sont chaque fois identiques.

4. Actionneur piézo-électrique selon l'une quelconque des revendications 2 à 3, **caractérisé en ce que** la distance réciproque des fausses électrodes est égale ou inférieure à l'écartement des électrodes dans la zone active.

5. Actionneur piézo-électrique selon l'une quelconque des revendications précédentes, **caractérisé en ce que** les fausses électrodes métalliques (10, 11) sont court-circuitées par une couche électroconductrice (14) de façon à intensifier la conduction thermique entre les fausses électrodes sans que la couche électroconductrice (14) n'arrive en contact avec les électrodes extérieures (3.1, 3.2).
